# EUROPÄISCHE PATENTSCHRIFT

(11) **EP 0 958 716 B1**
(45) Veröffentlichungstag und Bekanntmachung des Hinweises auf die Patenterteilung: **29.01.2003**
(21) Anmeldenummer: 98909355.4
(22) Anmeldetag: 09.02.1998
(51) Int. Cl.: H05B 41/38, G01R 31/28, G01R 31/24

(54) **VERFAHREN ZUM AUFFINDEN DER RESONANZFREQUENZ EINES ELEKTRISCHEN SCHWINGKREISES**
METHOD FOR DETERMINING THE RESONANCE FREQUENCY OF AN ELECTRIC RESONANT CIRCUIT
PROCEDE POUR DETERMINER LA FREQUENCE DE RESONANCE D'UN CIRCUIT ELECTRIQUE RESONNANT

(30) Priorität: 08.02.1997 DE 19704765; 04.02.1998 DE 19804309
(43) Veröffentlichungstag der Anmeldung: 24.11.1999
(73) Patentinhaber: ROBERT BOSCH GMBH, 70442 Stuttgart (DE)
(72) Erfinder: LAUBENSTEIN, Rüdiger, D-72800 Eningen (DE); EXNER, Ulrich, D-72762 Reutlingen (DE); DAMERAU, Ernst, D-72793 Pfullingen (DE); KERN, Robert, D-77830 Bühlertal (DE)
(86) Internationale Anmeldenummer: DE9800344
(87) Internationale Veröffentlichungsnummer: WO98035538

(56) Entgegenhaltungen:
- EP-A- 0 271 396
- EP-A- 0 413 991
- EP-A- 0 744 883
- MIZUNO T, ISHIKAWA T: "High frequency operation of metal-halide lamp controlled by microcomputer." JOURNAL OF ILLUMINATING ENGINEERING OF JAPAN, Bd. 71, Nr. 10, Oktober 1987, JAPAN, Seiten 622-625, XP002068934

## Beschreibung

### Stand der Technik

Die Erfindung geht aus von Verfahren zum Auffinden der Resonanzfrequenz eines elektrischen Schwingkreises, insbesondere eines Startschwingkreises für Hochdruck-Gasentladungslampen, der im Oberbegriff des Anspruchs 1 definierten Gattung.

Bei einem aus der EP-A 271 369 bekannten Verfahren dieser Art wird die Resonanzfrequenz beim Startvorgang einer Gasentladungslampe durch Frequenzwobbeln ermittelt. Dabei wird jeweils eine Frequenzrampe stetig durchfahren von einem minimalen Wert hin zu einem maximalen und wieder zurück. Jedesmal bei Durchfahren der Resonanzfrequenz wird der Schwingkreis kurzzeitig angeregt. Ein anderes Verfahren sieht das Durchfahren einer Frequenzrampe vor. Bei Erreichen der Resonanzfrequenz schwingt der Schwingkreis auf. Eine weitere Möglichkeit besteht darin, den Aufbau einer selbstschwingenden Schaltung vorzusehen, in welcher der Resonanzkreis die Schwingfrequenz selbst einstellt.

Allen diesen bekannten Verfahren haftet der Nachteil an, daß sie nicht in allen Belangen zufriedenstellend arbeiten und/oder recht aufwendig sind und kostenträchtigen Einsatz von besonderen Bauelementen benötigen.

### Vorteile der Erfindung

Das erfindungsgemäße Verfahren zum Auffinden der Resonanzfrequenz eines elektrischen Schwingkreises mit den kennzeichnenden Merkmalen des Anspruchs 1 hat demgegenüber den Vorteil, daß es ermöglicht, die toleranzbehaftete Resonanzfrequenz eines anzusteuernden elektrischen Schwingkreises in kurzer Zeit mit geringem Aufwand möglichst genau trifft bzw. feststellt und findet.

Gemäß der grundlegenden Lösung vorliegender Erfindung wird die Frequenzsuche in einem Suchlauf mit einzelnen Stichversuchen vorgenommen, bei den Stichversuchen jeweils eine bestimmte, feste Frequenz verwendet, und jede feste Frequenz nach einem bestimmten Suchschema ausgewählt und eingesetzt.

Die Erfindung stellt ein rein gesteuertes, zeitoptimiertes Suchverfahren zur Verfügung. Es entfällt dadurch die Notwendigkeit einer selbstschwingenden Schaltung, was insbesondere im Bereich sehr hoher Frequenzen schwierig zu realisieren ist. Darüber hinaus entfällt sogar die Notwendigkeit, zu erkennen, ob man sich beim Suchen der tatsächlichen Resonanzfrequenz nähert oder sich von ihr entfernt. Eine solche Erkennung müßte sonst über eine Phasendedektion erfolgen, welches mit größerem Hardwareaufwand verbunden ist. Ist in dem Steuergerät, in welchem der elektrische Schwingkreis enthalten ist, ein Mikrokontroller vorgesehen, was heute sehr oft der Fall sein kann, dann können die sonst notwendigen Hardwareschaltungen entfallen und durch Softwarefunktionen ersetzt werden, welche vom Mikrokontroller durchgeführt werden.

Durch die in den weiteren Ansprüchen niedergelegten Maßnahmen sind vorteilhafte Weiterbildungen und Verbesserungen des im Anspruch 1 angegebenen Verfahrens möglich.

In besonders vorteilhafter Weiterbildung der Erfindung wird bei dem Suchschema der erste Stichversuch mit der Mittenfrequenz fₘᵢₜₜ durchgeführt, wobei die Mittenfrequenz fₘᵢₜₜ der Mittelwert aus minimal fₘᵢₙ und maximal fₘₐₓ möglicher Resonanzfrequenz ist.

Gemäß einer besonders vorteilhaften Ausgestaltung des erfindungsgemäßen Verfahrens wird der Frequenzbereich zwischen minimal fₘᵢₙ und maximal fₘₐₓ möglicher Resonanzfrequenz in äquidistante Schritte Δf aufgeteilt wird, und die Anzahl der Schritte dabei in Berücksichtigung des Verhältnisses von Frequenzbereich zu Bandbreite des Schwingkreises gewählt ist.

In besonders zweckmäßiger Weiterbildung dieser Ausgestaltung des erfindungsgemäßen Verfahrens der zweite Stichversuch bei der festen Frequenz fₘᵢₜₜ +Δf, der dritte Stichversuch bei der festen Frequenz fₘᵢₜₜ -Δf, oder auch umgekehrt, vorgenommen wird.

Entsprechend einer weiteren besonders vorteilhaften Ausgestaltung der Erfindung ist bei diesem Verfahren vorgesehen, daß die weiteren Stichversuche bei den Testfrequenzen
fₘᵢₜₜ +2Δf, fₘᵢₜₜ -2Δf;
fₘᵢₜₜ +3Δf, fₘᵢₜₜ -3Δf;
fₘᵢₜₜ +4Δf, fₘᵢₜₜ -4Δf;
fₘᵢₜₜ +5Δf, fₘᵢₜₜ -5Δf, und so weiter, vorgenommen wird.

Gemäß einer anderen sehr zweckmäßigen Ausgestaltung der Erfindung wird die in einem Suchlauf ermittelte Resonanzfrequenz fᵣₑₛ gespeichert und steht als quasi Lernfrequenz fₗₑᵣₙ bei einem nachfolgenden Suchlauf als Ausgangsfrequenz für diesen Suchlauf zur Verfügung. Beim nächsten Suchvorgang, beispielsweise nach Ausund Wiedereinschaltung des den Schwingkreis enthaltenden Steuergerätes, beginnt der Suchvorgang nicht bei fₘᵢₜₜ, sondern bei dem zuvor gelernten und gespeicherten Wert fₗₑᵣₙ.

In besonders vorteilhafter Weiterbildung dieser Ausgestaltung der Erfindung erfolgt die Speicherung der Lernfrequenz fₗₑᵣₙ in einem nichtflüchtigen Speicher. In weiterer Ausgestaltung kann dazu die Speicherung der Lernfrequenz fₗₑᵣₙ in einer EEPROM-Zelle eines Mikrokontrollers erfolgen, wobei die Lernfrequenz fₗₑᵣₙ als Steuerspannung für einen spannungsgesteuerten Oszillator ablegbar ist. Besonders zweckmäßig ist es, jedesmal denjenigen Frequenzwert abzuspeichern, der beim neuesten Suchlauf ermittelt wurde.

In weiterer Verbesserung dieser Ausgestaltungen des erfindungsgemäßen Verfahrens wird die in einem Suchlauf ermittelte Resonanzfrequenz fᵣₑₛ nur dann erneut als Lernfrequenz fₗₑᵣₙ gespeichert, wenn der Abstand zwischen dem alten abgespeicherten und dem neu ermittelten Wert einen bestimmten Betrag überschreitet. Dadurch kann erreicht werden, daß die Anzahl der Neuabspeicherungen reduziert wird. Dies ist dann von besonderem Vorteil, wenn die Anzahl der Einschaltvorgänge des Steuergerätes, in welchem der Schwingkreis eingebaut ist, größer ist als die Anzahl der maximal zulässigen Schreibzyklen des nichtflüchtigen Datenspeichers.

Gemäß einer anderen vorteilhaften Weiterbildung des erfindungsgemäßen Verfahrens wird bei Erreichen einer der durch die minimal fₘᵢₙ und maximal fₘₐₓ mögliche Resonanzfrequenz gegebenen Grenzen während eines Suchlaufs, die nachfolgende Suche nur noch in der Richtung auf die jeweilige andere Grenze hin durchgeführt.

Eine weitere zweckmäßige Ausgestaltung des erfindungsgemäßen Verfahrens sieht vor, daß nach einem kompletten erfolglosen Suchlauf dieser wiederholt wird und dabei gegebenenfalls erneut bei der gespeicherten Lernfrequenz fₗₑᵣₙ begonnen wird. Diese Ausgestaltung ist bei solchen Anwendungen von besonderem Nutzen, wo das Treffen der Resonanzfrequenz fᵣₑₛ danach beurteilt wird, ob beim Aufschwingen des elektrischen Schwingkreises ein erwünschter Durchschlag, beispielsweise in einer zu zündenden Hochdruck-Gasentladungslampe, stattgefunden hat und bei denen es durch zeitweises Auftreten hoher Durchschlagsspannungen trotz genau getroffener Resonanzfrequenz fᵣₑₛ nicht beim ersten Versuch zum Durchschlag und damit zur Zündung kommt.

Eine weitere vorteilhafte Modifikation des erfindungsgemäßen Verfahrens sieht vor, daß der Suchlauf zunächst nicht komplett durchfahren wird, sondern nur in einem eingeschränkten Suchbereich, insbesondere von Lernfrequenz fₗₑᵣₙ +- n*Δf, wobei n so gewählt ist, daß die typisch auftretende Drift der Resonanzfrequenz innerhalb des ausgewählten Suchbereichs liegt. In zweckmäßiger Weiterbildung dieser Modifikation ist vorgesehen, daß dann, wenn das Erfolgskriterium nicht innerhalb des eingeschränkten Suchbereichs gefunden wird, die Suche zunächst noch einige Male nur im eingeschränkten Suchbereich durchgeführt wird, ehe gegebenenfalls die Suche auf den gesamten Suchbereich ausgedehnt wird. Dies ist auch hier von besonderem Vorteil, wenn die Anzahl der Einschaltvorgänge des Steuergerätes, in welchem der Schwingkreis eingebaut ist, größer ist als die Anzahl der maximal zulässigen Schreibzyklen der nichtflüchtigen Datenspeichers. Entsprechend einer besonders zweckmäßigen Ausgestaltung dieser Weiterbildung ist der eingeschränkte Suchbereich nach jeder erfolglosen Suchreihe schrittweise bis zum maximalen Suchbereich erweiterbar.

Wird das Verfahren nach der Erfindung, so wie es bisher beschrieben ist, zum Auffinden der Resonanzfrequenz eines Startschwingkreises für Hochdruck-Gasentladungslampen, bei denen eine gegenüber der Betriebsversorgungsspannung erhöhte Zündspannung vorgesehen ist, verwendet, dann ist entsprechend einer besonders vorteilhaften und zweckmäßigen Weiterbildung der Erfindung vorgesehen, daß die Frequenzsuche mit einer Spannung durchgeführt wird, die unterhalb der Zündspannung liegt, der Strom im Resonanzkreis gemessen wird, das Maximum des gemessenen Stroms bestimmt wird und die Resonanzfreqeunz beim maximalen Strom ermittelt wird. Diese Weiterbildung der Erfindung ermöglicht es, die Frequenzsuche in einer Reihe von Versuchen durchzuführen, ohne die Startschaltung mit zu hoher Belastung in ihrer Lebensdauer zu gefährden.

In weiterer Ausgestaltung dieser zweckmäßigen Weiterbildung wird bei der Frequenzsuche als die Spannung unterhalb der Zündspannung die Betriebsversorgungsspannung ohne Anlegen der Zündspannung verwendet. Entsprechend einem besonderen Anwenwendungsfall wird als Betriebsversorgungsspannung die Batteriespannung eines Kraftfahrzeuges verwendet.

### Zeichnung

Die Erfindung ist anhand mehrerer in der Zeichnung dargestellter Ausführungsbeispiele in der nachfolgenden Beschreibung näher erläutert. Es zeigen:
- Fig. 1: ein Diagramm der Suchfrequenzen über der Zeit, gemäß dem grundlegenden erfindungsgemäßen Verfahren, bei dem von der Frequenz fₘᵢₜₜ gestartet wird;
- Fig. 2: ein Diagramm der Suchfrequenzen über der Zeit ähnlich dem in Fig. 1, wobei von einer abgespeicherten Lernfrequenz fₗₑᵣₙ gestartet wird;
- Fig. 3: ein Diagramm der Suchfrequenzen über der Zeit gemäß einer modifizierten Ausführungsform des erfindungsgemäßen Verfahrens, wobei nach erfolglosem Suchverlauf eine andere Suchstrategie in Fortsetzung genutzt wird;
- Fig. 4: ein Diagramm der Suchfrequenzen über der Zeit gemäß einer weiteren Modifikation des erfindungsgemäßen Verfahrens mit einer Suchstrategie, bei der zumindest zunächst der Suchbereich eingeschränkt ist, und
- Fig. 5: ein Diagramm der Suchfrequenzen über der Zeit ähnlich dem in Fig. 4, bei dem der eingeschränkte Suchbereich schrittweise erweitert wird.

### Beschreibung der Ausführungsbeispiele

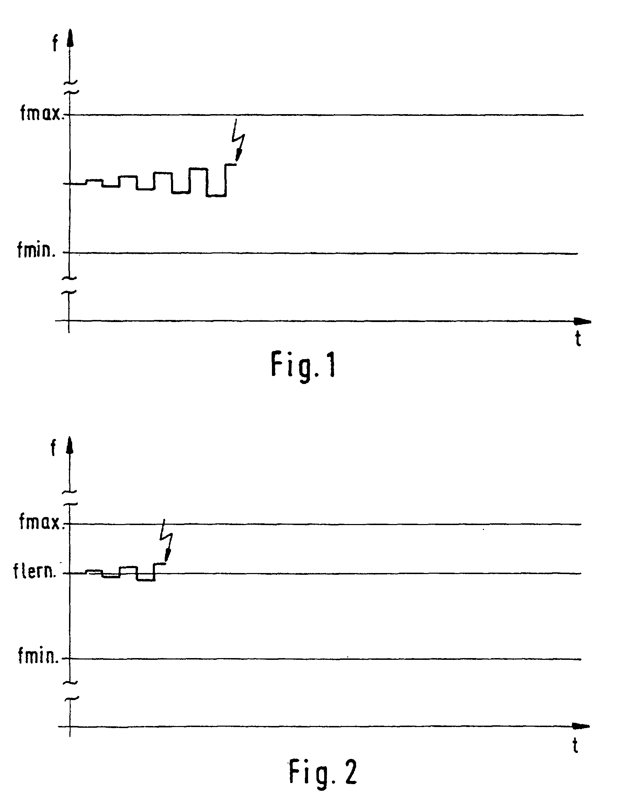

In Fig. 1 sind in einem Diagramm die Suchfrequenzen über der Zeit gemäß dem grundlegenden erfindungsgemäßen Verfahren aufgetragen. Bei dem erfindungsgemäßen Verfahren wird nach der zugrunde liegenden Idee die Frequenzsuche in einem Suchlauf mit einzelnen Stichversuchen vorgenommen. Bei den Stichversuchen wird jeweils eine bestimmte, feste Frequenz verwendet, und jede feste Frequenz ist nach einem bestimmten Suchschema ausgewählt und wird nach einem bestimmten Muster eingesetzt. Dabei wird mit dem allerersten Suchlauf zur Auffindung der Resonanzfrequenz des elektrischen Schwingkreises mit der Mittenfrequenz fₘᵢₜₜ gestartet. Die Mittenfrequenz fₘᵢₜₜ ist als diejenige Frequenz definiert, die in der Mitte zwischen minimal (fₘᵢₙ) und maximal (fₘₐₓ) möglicher Resonanzfrequenz liegt, also den Mittelwert aus diesen beiden Grenzwerten bildet. Entsprechend dem angewandten Suchschema wird der erste Stichversuch mit der Mittenfrequenz (fₘᵢₜₜ ) beginnend durchgeführt. Der nächst Stichversuch erfolgt bei einer anderen bestimmten und festen Frequenz, die sich von der ersten um einen diskreten Wert Δf unterscheidet.

Gemäß einer Variante des erfindungsgemäßen Verfahrens wird der Frequenzbereich zwischen minimal fₘᵢₙ und maximal fₘₐₓ möglicher Resonanzfrequenz in äquidistante Schritte Δf aufgeteilt. Die Anzahl der Schritte ist dabei in Berücksichtigung des Verhältnisses von Frequenzbereich zu Bandbreite des Schwingkreises gewählt, sie richtet sich also nach diesem Verhältnis. Der so ermittelte Abstand zwischen zwei benachbarten Such- oder Testfrequenzen wird als Δf bezeichnet.

Bei dem erfindungsgemäßen Verfahren wird der zweite Stichversuch bei der festen Frequenz fₘᵢₜₜ +Δf, der dritte Stichversuch bei der festen Frequenz fₘᵢₜₜ -Δf, oder auch umgekehrt, vorgenommen. Die weiteren Stichversuche werden bei den Testfrequenzen
fₘᵢₜₜ +2Δf, fₘᵢₜₜ -2Δf;
fₘᵢₜₜ +3Δf, fₘᵢₜₜ -3Δf;
fₘᵢₜₜ +4Δf, fₘᵢₜₜ -4Δf;
fₘᵢₜₜ +5Δf, fₘᵢₜₜ -5Δf, und so weiter, vorgenommen.

Dies setzt sich solange fort, bis die Resonanzfrequenz fᵣₑₛ gefunden ist bzw. bis das bei der Resonanzfrequenz fᵣₑₛ eintretende Erfüllungsereignis, beispielsweise der Durchschlag und das Zünden einer Gasentladungslampe, eintritt. Dies ist in den Figuren jeweils durch den gezackten Pfeil dargestellt. So tritt dies z.B. bei dem in Fig. 1 dargestellten Fall nach dem 10. Stichversuch ein.

Gemäß einer besonderen Ausgestaltung der Erfindung, die das Auffinden der Resonanzfrequenz fᵣₑₛ in der Praxis besonders schnell und sicher ermöglicht, wird die in einem Suchlauf ermittelte Resonanzfrequenz fᵣₑₛ gespeichert. Sie steht dann quasi als Lernfrequenz fₗₑᵣₙ bei einem nachfolgenden Suchlauf als Ausgangsfrequenz für diesen Suchlauf zur Verfügung. Dieser Fall ist im Diagramm gemäß Fig. 2 dargestellt. Die Lernfrequenz fₗₑᵣₙ unterscheidet sich dabei von der Mittenfrequenz fₘᵢₜₜ, von der im Beispiel gemäß Fig. 1 ausgegangen ist. Beim nächsten Suchvorgang, beispielsweise nach Aus- und Wiedereinschaltung des den Schwingkreis enthaltenden Steuergerätes, beginnt der Suchvorgang nicht bei fₘᵢₜₜ, sondern bei dem zuvor gelernten und gespeicherten Wert fₗₑᵣₙ. Wie im Diagramm von Fig. 2 gezeigt, wird dadurch die Resonanzfrequenz fᵣₑₛ bzw. das Erfüllungsereignis bereits nach dem 5. Stichversuch gefunden bzw. erreicht.

Die Speicherung der Lernfrequenz fₗₑᵣₙ erfolgt in zweckmäßiger Weise in einem nichtflüchtigen Speicher. In weiterer Ausgestaltung kann dazu die Speicherung der Lernfrequenz fₗₑᵣₙ in einer EEPROM-Zelle eines Mikrokontrollers erfolgen. Dort wird die Lernfrequenz fₗₑᵣₙ als Steuerspannung für einen spannungsgesteuerten Oszillator, einen VCO, abgelegt. Besonders zweckmäßig ist es, jedesmal denjenigen Frequenzwert abzuspeichern, der beim neuesten Suchlauf ermittelt wurde.

In manchen Fällen ist von besonderem Vorteil, die in einem Suchlauf ermittelte Resonanzfrequenz fᵣₑₛ nur dann erneut als Lernfrequenz fₗₑᵣₙ zu speichern, wenn der Abstand zwischen dem alten abgespeicherten und dem neu ermittelten Wert einen bestimmten Betrag überschreitet. Dadurch kann erreicht werden, daß die Anzahl der Neuabspeicherungen reduziert wird. Dies ist dann besonders wichtig, wenn die Anzahl der Einschaltvorgänge des Steuergerätes, in welchem der Schwingkreis eingebaut ist, größer ist als die Anzahl der maximal zulässigen Schreibzyklen des nichtflüchtigen Datenspeichers.

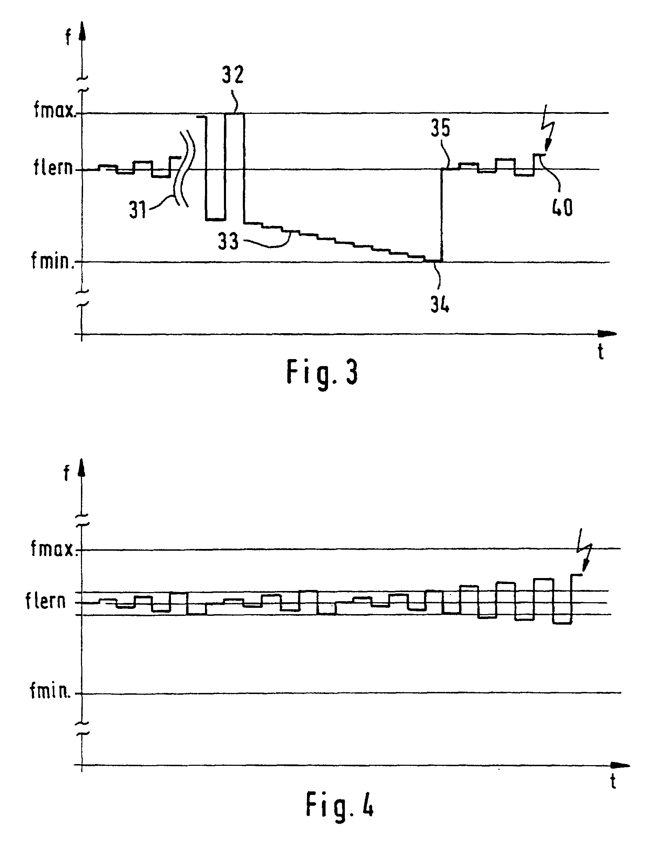

In Fig. 3 ist eine weitere Ausgestaltungsmöglichkeit des erfindungsgemäßen Verfahrens dargestellt. Beim Suchvorgang kann es vorkommen, daß die Grenzen fₘᵢₙ und fₘₐₓ des Suchbereichs erreicht werden, ohne daß die Resonanzfrequenz fᵣₑₛ gefunden wurde bzw. das Erfüllungsereignis eingetreten ist. Ist dies der Fall, wie in Fig. 3 durch die Schlangenlinien 31 dargestellt, und bei 32 mit der Maximalfrequenz fₘₐₓ erreicht, dann wird die nachfolgende Suche nur noch in der Richtung auf die jeweilige andere Grenze hin durchgeführt. Dies ist in Fig. 3 mit den Stufen 33 angedeutet, d.h. bei jedem neuen Stichversuch wird die Suchfrequenz um eine Stufe erniedrigt, bis die Grenze fₘᵢₙ erreicht ist. Bei Erreichen einer der durch die minimal fₘᵢₙ und maximal fₘₐₓ mögliche Resonanzfrequenz gegebenen Grenzen während eines Suchlaufs, wird also die Suchrichtung umgekehrt und nur noch in einer Richtung gesucht. In Fig. 3 ist eine weitere Möglichkeit gezeigt, die das erfindungsgemäße Verfahren bietet. Wird eine Grenze, beispielsweise fₘᵢₙ bei Stufe 34 erreicht, dann kann die gesamte Suche wieder von vorne wiederholt werden. Der nachfolgende Suchvorgang beginnt mit dem Stichversuch bei der Lernfrequenz fₗₑᵣₙ mit Stufe 35, durchläuft dann das in Fig. 1 dargestellte normale Grundschema und endet bei 40 im Auffinden der Resonanzfrequenz. Nach einem kompletten erfolglosen Suchlauf diesen zu wiederholen und dabei gegebenenfalls erneut bei der gespeicherten Lernfrequenz fₗₑᵣₙ zu beginnen, ist bei solchen Anwendungen von besonderem Nutzen, wo das Treffen der Resonanzfrequenz fᵣₑₛ danach beurteilt wird, ob beim Aufschwingen des elektrischen Schwingkreises ein erwünschter Durchschlag, beispielsweise in einer zu zündenden Hochdruck-Gasentladungslampe, stattgefunden hat und bei denen es durch zeitweises Auftreten hoher Durchschlagsspannungen trotz genau getroffener Resonanzfrequenz fᵣₑₛ nicht beim ersten Versuch zum Durchschlag und damit zur Zündung kommt.

Eine weitere vorteilhafte Modifikation der Erfindung besteht darin, daß der Suchlauf zunächst nicht komplett durchfahren wird, sondern nur in einem eingeschränkten Suchbereich durchgeführt wird, wie dies anhand des Diagramms von Fig. 4 dargestellt ist. In diesem Beispiel werden sieben Stichversuche ausgehend von der Lernfrequenz fₗₑᵣₙ ausgehend in je 3 Stufen unter und oberhalb derselben durchgeführt. Generell gilt, ausgehend von der Lernfrequenz fₗₑᵣₙ +- n*Δf, wobei n so gewählt ist, daß die typisch auftretende Drift der Resonanzfrequenz innerhalb des ausgewählten Suchbereichs liegt. In zweckmäßiger Weiterbildung dieser Modifikation ist vorgesehen, daß dann, wenn das Erfolgskriterium nicht innerhalb des eingeschränkten Suchbereichs gefunden wird, die Suche zunächst noch einige Male nur im eingeschränkten Suchbereich durchgeführt wird, ehe gegebenenfalls die Suche auf den gesamten Suchbereich ausgedehnt wird, wie dies im dargestellten Beispiel nach der dritten Wiederholung eingeleitet wird. Dies ist auch hier von besonderem Vorteil, wenn die Anzahl der Einschaltvorgänge des Steuergerätes, in welchem der Schwingkreis eingebaut ist, größer ist als die Anzahl der maximal zulässigen Schreibzyklen der nichtflüchtigen Datenspeichers.

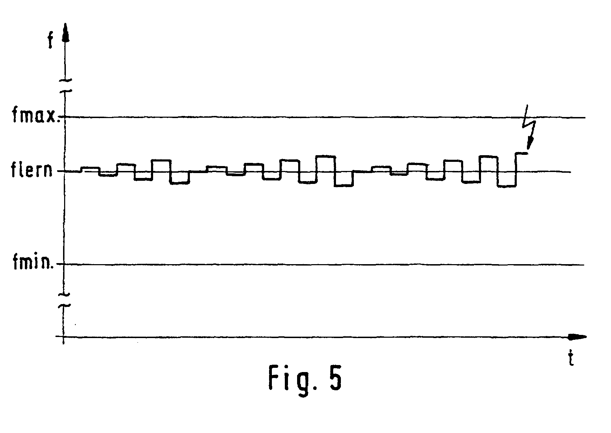

Entsprechend einer besonders zweckmäßigen Ausgestaltung dieser gerade beschriebenen Ausführungsform des erfindungsgemäßen Verfahrens ist anhand der Fig. 5 eine Weiterbildung gezeigt. Der eingeschränkte Suchbereich wird nach jeder erfolglosen Suchreihe, schrittweise bis zum maximalen Suchbereich erweitert, bis das Erfüllungsereignis eintritt. Im gezeigten Beispiel sind zwei vergebliche Versuchsreihen im eingeschränkten Suchbereich und ein kompletter Suchlauf gemäß der Grundidee der Erfindung gezeigt.

Das erfindungsgemäße Verfahren läßt sich besonders dann, wenn im Steuergerät, in dem der elektrische Schwingkreis verwendet wird, mit einem Mikrokontroller ausgestattet ist, was heute oft und zunehmend der Fall ist, sehr flexibel und sehr einfach in Softwarefunktionen realisieren. Dies erübrigt aufwendige Hardwarerealisierungen.

Wird das Verfahren nach der Erfindung, so wie es bisher beschrieben ist, zum Auffinden der Resonanzfrequenz eines Startschwingkreises für Hochdruck-Gasentladungslampen, bei denen eine gegenüber der Betriebsversorgungsspannung erhöhte Zündspannung vorgesehen ist, verwendet, dann ist entsprechend einer besonders vorteilhaften und zweckmäßigen Weiterbildung der Erfindung vorgesehen, die Frequenzsuche mit einer Spannung durchzuführen, die unterhalb der Zündspannung liegt. Es wird der Strom im Resonanzkreis gemessen, das Maximum des gemessenen Stroms wird bestimmt und es wird die Resonanzfreqeunz ermittelt, die beim maximalen Strom auftritt. Diese Weiterbildung der Erfindung ermöglicht es, die Frequenzsuche in einer Reihe von Versuchen durchzuführen, ohne die Startschaltung mit zu hoher Belastung in ihrer Lebensdauer zu gefährden.

In weiterer Ausgestaltung dieser zweckmäßigen Weiterbildung wird bei der Frequenzsuche als die Spannung unterhalb der Zündspannung die Betriebsversorgungsspannung ohne Anlegen der Zündspannung verwendet.

Entsprechend einem besonderen Anwenwendungsfall wird als Betriebsversorgungsspannung die Batteriespannung eines Kraftfahrzeuges verwendet. In diesem Kraftfahrzeug werden Hochdruck-Gasentladungslampen, die erheblich bessere Lichtausbeute bei geringerem Energieverbrauch aufweisen, mit Zündmodulen gestartet, deren Resonanzfrequenz des Startschwingkreises entsprechend dem erfindungsgemäßen Verfahren ermittelt wird.

Zur Frequenzsuche wird also entsprechend dieser Ausführungsform der Resonanzkreis mit einer geringen Spannung beaufschlagt, so daß selbst im Resonanzfall die Lampe nicht zünden kann. Der Strom wird zur Bestimmung der Resonanzfrequenz ausgewertet. Durch diese Maßnahme wird die thermische Belastung der Entstufe eines Lampensteuergerätes, insbesondere des Takttransistors, die durch Frequenzsuche verursacht wird, gering gehalten. Dadurch entfällt auch die Beschränkung, daß wegen der hohen oder zu hohen Belastung nur wenige Versuche bei der Suche nach der Resonanzfrequenz durchgeführt werden können und dadurch zusätzlich die verwendeten Frequenzsprünge für das Δf mit beispielsweise 170 kHz sehr groß waren. Bei solchen Werten und Beschränkungen ist das einwandfreie Zünden der Lampe nicht immer gewährleistet gewesen. Dies besonders dann, wenn man beim Zünden einer heißen Lampe Zündzeiten vom 3 ms benötigt und den Takttransistor nur für 6 ms belasten darf. Dadurch ist man auf nur zwei Versuche mit unterschiedlicher Frequenz beschränkt.

Weil der Startschwingkreis auch stark temperaturabhängig ist, ist auch kein Verlass auf den vorher ermittelten Wert der Resonanzfrequenz. Dabei ist gelegentlich auch noch zu berücksichtigen, daß die Lampe bei einem Wert bereits gezündet hat, der nicht der tatsächlichen Resonanzfrequenz entspricht, wodurch nicht zu gewährleisten ist, daß der Lampe auch die maximale Energie zur Verfügung gestellt worden ist.

Bei Beachtung dieses Hintergrundes eröffnet daher diese besondere Ausführungsform der erfindungsgemäßen Resonanzsuche ohne größeren Aufwand und ohne den Takttransistor im wesentlichen zu beanspruchen, die Resonanzfrequenz des Schwingkreises im Rahmen der Meßgenauigkeit von etwa 5 kHz in einem recht engen Bereich zu bestimmen. Dadurch wird eine deutlich höhere Zündspannung und eine größere Übernahmeenergie erhalten.

## Patentansprüche

1. Verfahren zum Auffinden der Resonanzfrequenz eines elektrischen Schwingkreises, insbesondere eines Startschwingkreises für Hochdruck-Gasentladungslampen, bei dem der Schwingkreis mit verschiedenen Frequenzen angeregt wird,
**dadurch gekennzeichnet, daß**
die Frequenzsuche in einem Suchlauf mit einzelnen Stichversuchen vorgenommen wird,
bei den Stichversuchen jeweils eine bestimmte, feste Frequenz verwendet wird, und
jede feste Frequenz nach einem bestimmten Suchschema ausgewählt ist und eingesetzt wird.

2. Verfahren nach Anspruch 1, **dadurch gekennzeichnet, daß** bei dem Suchschema der erste Stichversuch mit der Mittenfrequenz (fₘᵢₜₜ) durchgeführt wird, wobei die Mittenfrequenz (fₘᵢₜₜ) der Mittelwert aus minimal (fₘᵢₙ) und maximal (fₘₐₓ) möglicher Resonanzfrequenz ist.

3. Verfahren nach Anspruch 1 oder 2, **dadurch gekennzeichnet, daß** der Frequenzbereich zwischen minimal (fₘᵢₙ) und maximal (fₘₐₓ) möglicher Resonanzfrequenz in äquidistante Schritte (Δf) aufgeteilt wird, und daß die Anzahl der Schritte dabei in Berücksichtigung des Verhältnisses von Frequenzbereich zu Bandbreite des Schwingkreises gewählt ist.

4. Verfahren nach einem der vorigen Ansprüche, **dadurch gekennzeichnet, daß** der zweite Stichversuch bei der festen Frequenz fₘᵢₜₜ +Δf, der dritte Stichversuch bei der festen Frequenz fₘᵢₜₜ -Δf, oder auch umgekehrt, vorgenommen wird.

5. Verfahren nach Anspruch 4, **dadurch gekennzeichnet, daß** die weiteren Stichversuche bei den Testfrequenzen
fₘᵢₜₜ +2Δf, fₘᵢₜₜ -2Δf;
fₘᵢₜₜ +3Δf, fₘᵢₜₜ -3Δf;
fₘᵢₜₜ +4Δf, fₘᵢₜₜ -4Δf;
fₘᵢₜₜ +5Δf, fₘᵢₜₜ -5Δf, und so weiter, vorgenommen wird.

6. Verfahren nach einem der vorigen Ansprüche, **dadurch gekennzeichnet, daß** die in einem Suchlauf ermittelte Resonanzfrequenz (fᵣₑₛ) gespeichert wird und als quasi Lernfrequenz (fₗₑᵣₙ) bei einem nachfolgenden Suchlauf als Ausgangsfrequenz für diesen Suchlauf zur Verfügung steht.

7. Verfahren nach Anspruch 6, **dadurch gekennzeichnet, daß** die Speicherung der Lernfrequenz (fₗₑᵣₙ) in einem nichtflüchtigen Speicher erfolgt.

8. Verfahren nach Anspruch 6 oder 7, **dadurch gekennzeichnet, daß** die Speicherung der Lernfrequenz (fₗₑᵣₙ) in einer EEPROM-Zelle eines Mikrokontrollers erfolgt, wobei die Lernfrequenz (fₗₑᵣₙ) als Steuerspannung für einen spannungsgesteuerten Oszillator ablegbar ist.

9. Verfahren nach einem der Ansprüche 6, 7 oder 8, **dadurch gekennzeichnet, daß** die in einem Suchlauf ermittelte Resonanzfrequenz (fᵣₑₛ) nur dann erneut als Lernfrequenz (fₗₑᵣₙ) gespeichert wird, wenn der Abstand zwischen dem alten abgespeicherten und dem neu ermittelten Wert einen bestimmten Betrag überschreitet.

10. Verfahren nach einem der vorigen Ansprüche, **dadurch gekennzeichnet, daß** bei Erreichen einer der durch die minimal (fₘᵢₙ) und maximal (fₘₐₓ) mögliche Resonanzfrequenz gegebenen Grenzen während eines Suchlaufs, die nachfolgende Suche nur noch in der Richtung auf die jeweilige andere Grenze hin durchgeführt wird.

11. Verfahren nach einem der vorigen Ansprüche, **dadurch gekennzeichnet, daß** nach einem kompletten erfolglosen Suchlauf dieser wiederholt wird und dabei gegebenenfalls erneut bei der gespeicherten Lernfrequenz (fₗₑᵣₙ) begonnen wird.

12. Verfahren nach einem der vorigen Ansprüche, **dadurch gekennzeichnet, daß** der Suchlauf zunächst nicht komplett durchfahren wird, sondern nur in einem eingeschränkten Suchbereich, insbesondere von Lernfrequenz (fₗₑᵣₙ) +- n*Δf, wobei n so gewählt ist, daß die typisch auftretende Drift der Resonanzfrequenz innerhalb des ausgewählten Suchbereichs liegt.

13. Verfahren nach Anspruch 12, **dadurch gekennzeichnet, daß** dann, wenn das Erfolgskriterium nicht innerhalb des eingeschränkten Suchbereichs gefunden wird, die Suche zunächst noch einige Male nur im eingeschränkten Suchbereich durchgeführt wird, ehe gegebenenfalls die Suche auf den gesamten Suchbereich ausgedehnt wird.

14. Verfahren nach Anspruch 13, **dadurch gekennzeichnet, daß** der eingeschränkte Suchbereich nach jeder erfolglosen Suchreihe schrittweise bis zum maximalen Suchbereich erweiterbar ist.

15. Verfahren nach einem der vorigen Ansprüche zum Auffinden der Resonanzfrequenz eines Startschwingkreises für Hochdruck-Gasentladungslampen, bei denen eine gegenüber der Betriebsversorgungsspannung erhöhte Zündspannung vorgesehen ist, **dadurch gekennzeichnet, daß**
die Frequenzsuche mit einer Spannung durchgeführt wird, die unterhalb der Zündspannung liegt,
der Strom im Resonanzkreis gemessen wird,
das Maximum des gemessenen Stroms bestimmt wird und
die Resonanzfreqeunz beim maximalen Strom ermittelt wird.

16. Verfahren nach Anspruch 15, **dadurch gekennzeichnet, daß** die Spannung unterhalb der Zündspannung die Betriebsversorgungsspannung ohne Anlegen der Zündspannung ist.

17. Verfahren nach Anspruch 15 oder 16, **dadurch gekennzeichnet, daß** als Betriebsversorgungsspannung die Batteriespannung eines Kraftfahrzeuges verwendet wird.

## Claims

1. Method for finding the resonant frequency of an electric resonant circuit, in particular of a starting resonant circuit for high-pressure gas discharge lamps, in which the resonant circuit is excited by different frequencies, **characterized in that** the frequency search is undertaken in a search run with the aid of individual spot checks, a specific, fixed frequency is used in each case in the spot checks, and each fixed frequency is selected and used according to a specific search scheme.

2. Method according to Claim 1, **characterized in that**, in the search scheme, the first spot check is carried out with the aid of the mid-frequency (fₘᵢₜₜ), the mid-frequency (fₘᵢₜₜ) being the mean value of the minimum (fₘᵢₙ) and maximum (fₘₐₓ) possible resonant frequencies.

3. Method according to Claim 1 or 2, **characterized in that** the frequency range between the minimum (fₘᵢₙ) and maximum (fₘₐₓ) possible resonant frequencies is divided into equidistant steps (Δf), and **in that** the number of the steps is selected in this case by considering the ratio of frequency range to bandwidth of the resonant circuit.

4. Method according to one of the preceding claims, **characterized in that** the second spot check is undertaken at the fixed frequency fₘᵢₜₜ +Δf, and the third spot check is undertaken at the fixed frequency fₘᵢₜₜ -Δf, or else vice versa.

5. Method according to Claim 4, **characterized in that** the further spot checks are undertaken at the test frequencies
fₘᵢₜₜ +2Δf, fₘᵢₜₜ -2Δf
fₘᵢₜₜ +3Δf, fₘᵢₜₜ -3Δf
fₘᵢₜₜ +4Δf, fₘᵢₜₜ -4Δf
fₘᵢₜₜ +5Δf, fₘᵢₜₜ -5Δf, and so on.

6. Method according to one of the preceding claims, **characterized in that** the resonant frequency (fᵣₑₛ) determined in a search run is stored and is available as a quasi learning frequency (fₗₑᵣₙ) in a subsequent search run as output frequency for this search run.

7. Method according to Claim 6, **characterized in that** the storage of the learning frequency (fₗₑᵣₙ) is performed in a nonvolatile memory.

8. Method according to Claim 6 or 7, **characterized in that** the storage of the learning frequency (fₗₑᵣₙ) is performed in an EEPROM cell of a microcontroller, it being possible for the learning frequency (fₗₑᵣₙ) to be stored as control voltage for a voltage controlled oscillator.

9. Method according to one of Claims 6, 7 or 8, **characterized in that** the resonant frequency (fᵣₑₛ) determined in a search run is stored anew as learning frequency (fₗₑᵣₙ) only whenever the spacing between the old, stored and the new, determined value overshoots a specific value.

10. Method according to one of the preceding claims, **characterized in that**, when one of the limits given by the minimum (fₘᵢₙ) and maximum (fₘₐₓ) possible resonant frequency is reached during a search run, the subsequent search is carried out further only in the direction of the respective other limit.

11. Method according to one of the preceding claims, **characterized in that**, after a complete, unsuccessful search run, the latter is repeated and restarted in this case, if appropriate, at the stored learning frequency (fₗₑᵣₙ).

12. Method according to one of the preceding claims, **characterized in that** the search run is firstly carried out not completely, but only in a restricted search area, in particular of the learning frequency (fₗₑᵣₙ) +- n*Δf, n being selected such that the typically occurring drift of the resonant frequency lies within the selected search area.

13. Method according to Claim 12, **characterized in that**, whenever the success criterion is not found within the restricted search area, the search is firstly further carried out a few times in the restricted search area before, if appropriate, the search is extended to the overall search area.

14. Method according to Claim 13, **characterized in that**, after each unsuccessful search series, the restricted search area can be widened in steps up to the maximum search area.

15. Method according to one of the preceding claims for finding the resonant frequency of a starting resonant circuit for high-pressure gas discharge lamps, in the case of which a starting voltage greater than the operating supply voltage is provided, **characterized in that** the frequency search is carried out with the aid of a voltage which is below the starting voltage, the current in the resonant circuit is measured, the maximum of the measured current is determined, and the resonant frequency is determined in the case of the maximum current.

16. Method according to Claim 15, **characterized in that** the voltage below the starting voltage is the operating supply voltage without application of the starting voltage.

17. Method according to Claim 15 or 16, **characterized in that** the battery voltage of a motor vehicle is used as operating supply voltage.

## Revendications

1. Procédé pour déterminer la fréquence de résonance d'un circuit électrique oscillant, notamment d'un circuit oscillant de démarrage de lampe à décharge de gaz à haute pression, selon lequel on excite le circuit oscillant avec différentes fréquences,
**caractérisé en ce qu'**
on effectue la recherche de la fréquence dans une boucle de recherche avec différentes recherches échantillons,
pour les recherches échantillons, on utilise chaque fois une fréquence fixe déterminée, et
on sélectionne et on introduit chaque fréquence fixe selon un schéma de recherche déterminé.

2. Procédé selon la revendication 1,
**caractérisé en ce que**
dans le schéma de recherche, on effectue la première recherche échantillon avec la fréquence médiane (fₘᵢₜₜ), cette fréquence médiane (fₘᵢₜₜ) étant la valeur moyenne du minimum (fₘᵢₙ) et du maximum (fₘₐₓ) de la fréquence de résonance possible.

3. Procédé selon les revendications 1 ou 2,
**caractérisé en ce que**
l'on divise la plage de fréquence comprise entre le minimum (fₘᵢₙ) et le maximum (fₘₐₓ) de la fréquence de résonance possible en des pas équidistants (Δf), et
on sélectionne le nombre de pas en tenant compte du rapport entre la plage de fréquence et la largeur de bande du circuit oscillant.

4. Procédé selon l'une des revendications précédentes
**caractérisé en ce qu'**
on effectue le second essai échantillon pour une fréquence fixe fₘᵢₜₜ +Δf, le troisième essai échantillon pour la fréquence fixe fₘᵢₜₜ -Δf ou inversement

5. Procédé selon la revendication 4,
**caractérisé en ce qu'**
on effectue les autres essais échantillons avec les fréquences d'essais suivante :
fₘᵢₜₜ +2Δf, fₘᵢₜₜ -2Δf ;
fₘᵢₜₜ +3Δf, fₘᵢₜₜ -3Δf ;
fₘᵢₜₜ +4Δf, fₘᵢₜₜ -4Δf ;
fₘᵢₜₜ +5Δf, fₘᵢₜₜ -5Δf etc.

6. Procédé selon l'une des revendications précédentes,
**caractérisé en ce que**
l'on enregistre en mémoire la fréquence de résonance (fᵣₑₛ) obtenue dans une recherche et on l'utilise comme quasi fréquence d'apprentissage (fₗₑᵣₙ) lors de la recherche suivante comme fréquence de départ pour cette recherche.

7. Procédé selon la revendication 6,
**caractérisé en ce que**
la mise en mémoire de la fréquence d'apprentissage (fₗₑᵣₙ) est enregistrée dans une mémoire non volatile.

8. Procédé selon les revendications 6 ou 7,
**caractérisé en ce que**
l'enregistrement en mémoire de la fréquence d'apprentissage (fₗₑᵣₙ) se fait dans une cellule EEPROM d'un microcontrôleur, la fréquence d'apprentissage (fₗₑᵣₙ) étant enregistrée comme tension de commande d'un oscillateur commandé en tension.

9. Procédé selon l'une quelconque des revendications 6, 7 ou 8,
**caractérisé en ce que**
la fréquence de résonance (fᵣₑₛ) obtenue dans une recherche n'est enregistrée de nouveau en mémoire comme fréquence d'apprentissage (fₗₑᵣₙ) que si la distance entre l'ancienne valeur enregistrée et la nouvelle valeur obtenue dépasse un certain niveau.

10. Procédé selon l'une des revendications précédentes,
**caractérisé en ce qu'**
on atteint l'une des limites données par la fréquence de résonance possible entre le minimum (fₘᵢₙ) et le maximum (fₘₐₓ) pendant une recherche, on effectue la recherche suivante seulement en direction de l'autre limite respective.

11. Procédé selon l'une des revendications précédentes,
**caractérisé en ce qu'**
après une recherche complète, sans succès, on répète cette recherche et le cas échéant on commence de nouveau par la fréquence d'apprentissage (fₗₑᵣₙ) mise en mémoire.

12. Procédé selon l'une des revendications précédentes,
**caractérisé en ce que**
l'on ne parcourt tout d'abord pas de manière complète la recherche mais seulement une plage de recherche limitée en particulier par rapport à la fréquence d'apprentissage (fₗₑᵣₙ) + - n*Δf, relation dans laquelle n est choisi pour que la dérive qui se produit de manière caractéristique de la fréquence de résonance se trouve à l'intérieur de la plage de recherche sélectionnée.

13. Procédé selon la revendication 12,
**caractérisé en ce que**
si le critère de succès n'est pas trouvé dans la plage de recherche limitée, on effectue la recherche tout d'abord à un nombre réduit de fois seulement dans la plage de recherche limitée avant d'étendre la recherche sur toute la plage de recherche.

14. Procédé selon la revendication 13,
**caractérisé en ce que**
la plage de recherche limitée est étendue après chaque série de recherches infructueuses, pas à pas jusqu'à la plage de recherche maximale.

15. Procédé selon l'une des revendications précédentes pour détecter la fréquence de résonance d'un circuit oscillant de démarreur de lampe à décharge de gaz à haute pression, selon lequel on prévoit une tension d'allumage augmentée par rapport à la tension d'alimentation de fonctionnement,
**caractérisé en ce que**
la recherche de fréquence est effectuée avec une tension inférieure à la tension d'allumage,
on mesure l'intensité de courant dans le circuit résonant,
on détermine le maximum de l'intensité de courant mesurée, et
on détermine la fréquence de résonance pour une intensité de courant maximum.

16. Procédé selon la revendication 15,
**caractérisé en ce que**
la tension inférieure à la tension d'allumage est la tension d'alimentation pour le fonctionnement sans appliquer la tension d'allumage.

17. Procédé selon les revendications 15 ou 16,
**caractérisé en ce que**
la tension d'alimentation de fonctionnement est la tension de la batterie d'un véhicule.
